# EUROPÄISCHE PATENTSCHRIFT

(11) **EP 4 334 728 B1**
(45) Veröffentlichungstag und Bekanntmachung des Hinweises auf die Patenterteilung: **26.02.2025**
(21) Anmeldenummer: 22716264.1
(22) Anmeldetag: 07.04.2022
(51) Int. Cl.: G01R 19/00, G01R 35/00

(54) **VERFAHREN ZUR PLAUSIBILISIERUNG EINER STROMMESSUNG ZWISCHEN EINEM ELEKTRISCHEN ENERGIESPEICHERSYSTEM UND EINEM ELEKTRISCHEN VERBRAUCHER**
METHOD FOR CHECKING THE PLAUSIBILITY OF A CURRENT MEASUREMENT BETWEEN AN ELECTRICAL ENERGY STORAGE SYSTEM AND AN ELECTRICAL CONSUMER
PROCÉDÉ DE CONTRÔLE DE PLAUSIBILITÉ D'UNE MESURE DE COURANT ENTRE UN SYSTÈME DE STOCKAGE D'ÉNERGIE ÉLECTRIQUE ET UN RÉCEPTEUR ÉLECTRIQUE

(30) Priorität: 03.05.2021 DE 102021204397
(43) Veröffentlichungstag der Anmeldung: 13.03.2024
(73) Patentinhaber: Robert Bosch GmbH, 70442 Stuttgart (DE)
(72) Erfinder: SCHNEIDER, Johannes, 70499 Stuttgart (DE)
(86) Internationale Anmeldenummer: PCT/EP2022/059223
(87) Internationale Veröffentlichungsnummer: WO 2022/233529

(56) Entgegenhaltungen:
- CN-A- 112 462 315
- JP-B2- 3 668 145
- US-A1- 2013 335 100
- US-A1- 2017 331 401

## Beschreibung

Die vorliegende Erfindung geht aus von einem Verfahren zur Plausibilisierung einer Strommessung zwischen einem elektrischen Energiespeichersystem und einem elektrischen Verbraucher.

### Stand der Technik

Elektrische Energiespeichersysteme, insbesondere Batterien, mit Lithium-Eisenphosphat-Chemie, abgekürzt LFP-Chemie, können aufgrund ihrer niedrigen Spannungslage besonders nützlich für bestimmte Batteriesysteme sein, zum Beispiel 12V-Bordnetz mit typischem Spannungsbereich 9V-16V, welcher mit 4 LFP-Zellen abgedeckt wird. Außerdem sind LFP-Zellen besonders sicher, insbesondere im Fall von Übertemperatur oder Kurzschluss.

Für einen Einsatz von LFP-Batterien für sicherheitskritische Anwendungen im Fahrzeug, die eine zuverlässige Vorhersage der aktuell verfügbaren Batterie-Leistungsfähigkeit und Batterie-Restenergiemenge benötigen, muss der SOC zuverlässig bestimmt werden können, insbesondere der aktuell niedrigst mögliche Ladezustand bekannt sein.

Elektrochemische Eigenschaften der LFP-Chemie erlauben in weiten Bereichen des Ladezustands keine SOC-Bestimmung via Messung der OCV-Kurve, weil sich die OCV-Spannung kaum verändert, wenn sich der Ladestand durch beispielsweise Stromentnahme verändert. Dies resultiert aus einer flachen Leerlaufspannungskennlinie der LFP-Chemie.

Es bietet sich daher an, mittels eines Batterie-Management-Systems dauerhaft den Strom zu messen der aus einer Batterie entnommen wird, das heißt, den Strom in jedem Modus des Batteriemanagementsystems zu überwachen, unter anderem auch im Standby-Modus, in dem ebenfalls Stromentnahmen vorgesehen sein können. Beispielsweise kann dies bei einer12V-Batterie für die Ruhestromversorgung des Fahrzeugs erforderlich sein.

Der für sicherheitskritische Anwendungen wichtige Worst-Case-Ladezustand, das heißt die niedrigst-mögliche Restenergiemenge, wird somit direkt von der Strom-Messgenauigkeit beeinflusst. Für längere Phasen des Standby-Modus wirken sich schon kleine Messungenauigkeiten stark auf den Worst-Case-Ladezustand aus und erlauben nur eine sehr konservative Einschätzung desselben, sodass eine eigentlich verfügbare Leistung einer Batterie dem Fahrzeug oder Verbraucher nicht freigegeben werden kann und damit nicht genutzt werden kann.

Eine wichtige Ursache für limitierte Messgenauigkeit einer Strommessung (für den hier betrachteten relevanten Fall niedriger Stromamplituden) ist insbesondere die EMV-Abweichung der Sensorik oder eine temperaturabhängige Offset-Ungenauigkeit des Analog-Digital-Wandlers. Es handelt sich also um Ungenauigkeiten der Strommessung, die jederzeit vorgehalten werden müssen, obwohl die Bedingungen, die zur Ungenauigkeit führen, nicht immer gegeben sind, insbesondere die vorgenannten EMV-Störungen oder besonders niedriger Temperaturbereich.

Die Druckschrift US 2013/0335100 beschreibt ein Verfahren zur Überprüfung der ordnungsgemäßen Funktionsweise eines Stromsensors.

Die Druckschrift DE102014219806A1 beschreibt eine Vorrichtung und ein Verfahren zur Prüfung einer Funktionsfähigkeit eines Stromsensors.

### Offenbarung der Erfindung

### Vorteile der Erfindung

Offenbart wird ein Verfahren zur Plausibilisierung einer Strommessung zwischen einem elektrischen Energiespeichersystem und einem elektrischen Verbraucher mit den Merkmalen des unabhängigen Patentanspruchs, wobei zwischen dem elektrischen Energiespeichersystem und dem elektrischen Verbraucher sind ein Kondensator und ein Schaltelement angeordnet sind.

Dabei wird ein erster Stromwert durch Messen eines elektrischen Stromes zwischen dem elektrischen Energiespeichersystem und dem elektrischen Verbraucher ermittelt.

Weiterhin wird das Schaltelement zum Trennen des elektrischen Energiespeichersystems von dem elektrischen Verbraucher angesteuert, sodass der elektrische Verbraucher von dem Kondensator mit elektrischer Energie versorgt wird.

Anschließend wird eine erste elektrische Spannung an dem Kondensator ermittelt sowie ein zweiter Stromwert in Abhängigkeit der ermittelten Spannung.

Anschließend erfolgt eine Plausibilisierung der Strommessung durch Vergleich des ersten Stromwertes mit dem zweiten Stromwert.

Das Verfahren ist vorteilhaft, da neben der eigentlichen Strommessung eine Plausibilisierung des gemessenen ersten Stromwertes erfolgt, welche prüft, ob ein Stromfluss tatsächlich stattfindet oder ein Messwert nur durch eine EMV-Störung beziehungsweise einen Analog-Digital-Wandler-Offset bedingt ist. Anhand der Spannung an dem Kondensator kann auf einen fließenden Strom rückgeschlossen werden. Ziel der Plausibilisierung ist eine Reduktion des vorgehaltenen Genauigkeitspuffers bei der Stromwerterfassung in Zeiten geringen Stromflusses. Daher ist das Verfahren in Zeiten geringen Stromflusses, beispielsweise in einer Standby-Situation, vorgesehen.

Weitere vorteilhafte Ausführungsformen der vorliegenden Erfindung sind Gegenstand der Unteransprüche.

Ein geeignetes Schaltelement kann beispielsweise ein Transistor, insbesondere ein MOSFET sein beziehungsweise diesen umfassen.

Das Verfahren kann insbesondere auch computerimplementiert umgesetzt werden.

Zweckmäßigerweise erfolgt eine Anpassung von bei der Strommessung zu berücksichtigenden Messunsicherheiten in Abhängigkeit des zweiten Stromwertes. Dies ist vorteilhaft, da dadurch insbesondere bei geringem Stromfluss der Ladezustand weniger konservativ abgeschätzt werden kann durch die angepassten Messunsicherheiten der Strommessung.

Zweckmäßigerweise wird die Funktionsfähigkeit des Schaltelementes in Abhängigkeit der ermittelten ersten elektrischen Spannung an dem Kondensator überprüft. Je nach Art und Messort der ersten elektrischen Spannung wird bei Überschreiten oder Unterschreiten einer vordefinierten Spannung die Funktionsfähigkeit des Schaltelementes beschieden. Dies ist vorteilhaft, um dessen Funktionsfähigkeit sicherzustellen.

Zweckmäßigerweise wird der erste Stromwert mit einem vordefinierten ersten Stromgrenzwert verglichen, wobei das Ansteuern in Abhängigkeit des Vergleichs erfolgt. Beispielsweise kann vorgesehen sein, dass das Ansteuern des Schaltelementes erst bei Unterschreiten des vordefinierten ersten Stromgrenzwertes erfolgt. Zusätzlich kann vorgesehen sein, dass der vordefinierte erste Stromgrenzwert für einen vordefinierten ersten Zeitraum unterschritten worden sein muss und erst dann ein Ansteuern des Schaltelementes erfolgt. Dies ist vorteilhaft, da das Verfahren insbesondere bei geringem Stromverbrauch vorteilhaft ist, wie oben erwähnt, und weiterhin ein Schalten bei hohem Strom aufgrund von möglichem Verschleiß des Schaltelementes vermieden wird.

Zweckmäßigerweise wird das Ansteuern des Schaltelementes zum Verbinden des elektrischen Energiespeichersystems mit dem Verbraucher angesteuert, sodass der elektrische Verbraucher von dem elektrischen Energiespeichersystem mit elektrischer Energie versorgt wird. Dies ist vorteilhaft, da der Kondensator typischerweise eine im Vergleich zu dem elektrischen Energiespeichersystem geringere Energiemenge speichern kann und somit den Verbraucher nur für kürzere Zeit versorgen kann, sodass durch das Verbinden die Versorgung wieder gesichert ist.

Zweckmäßigerweise wird das Schaltelement zum Verbinden in Abhängigkeit einer zweiten elektrischen Spannung an dem Kondensator angesteuert. Dies ist vorteilhaft, um beispielsweise bei einem Über- oder Unterschreiten eines vordefinierten Spannungsgrenzwertes das elektrische Energiespeichersystem unmittelbar mit dem Verbraucher zu verbinden, was insbesondere im Falle einer hohen Energieanforderung durch den Verbraucher auftreten kann.

Weiterhin ist Gegenstand der Erfindung ein Computerprogramm, welches eingerichtet ist, alle Schritte des oben beschriebenen Verfahrens auszuführen. Somit können die oben genannten Vorteile erzielt werden.

Weiterhin ist Gegenstand der Erfindung ein maschinenlesbares Speichermedium, auf dem das vorgenannten Computerprogramm gespeichert ist. Somit können die oben genannten Vorteile erzielt werden.

Weiterhin ist Gegenstand der Erfindung eine elektronische Steuereinheit, die eingerichtet ist, alle Schritte des oben genannten Verfahrens auszuführen. Somit können die oben genannten Vorteile erzielt werden.

Weiterhin ist Gegenstand der Erfindung eine Vorrichtung, umfassend eine erfindungsgemäße elektronische Steuereinheit, ein elektrisches Energiespeichersystem und einen elektrischen Verbraucher, wobei zwischen beiden ein Kondensator und ein Schaltelement angeordnet sind.

### Kurze Beschreibung der Zeichnungen

Vorteilhafte Ausführungsformen der Erfindung sind in den Figuren dargestellt und in der nachfolgenden Beschreibung näher ausgeführt.

Es zeigen:
- Figur 1: ein Flussdiagramm eines erfindungsgemäßen Verfahrens gemäß einer ersten Ausführungsform;
- Figur 2: ein Flussdiagramm eines erfindungsgemäßen Verfahrens gemäß einer zweiten Ausführungsform;
- Figur 3: ein Flussdiagramm eines erfindungsgemäßen Verfahrens gemäß einer dritten Ausführungsform;
- Figur 4: eine schematische Darstellung einer erfindungsgemäßen Vorrichtung gemäß einer Ausführungsform.

### Ausführungsformen der Erfindung

Gleiche Bezugszeichen bezeichnen in allen Figuren gleiche Vorrichtungskomponenten oder gleiche Verfahrensschritte.

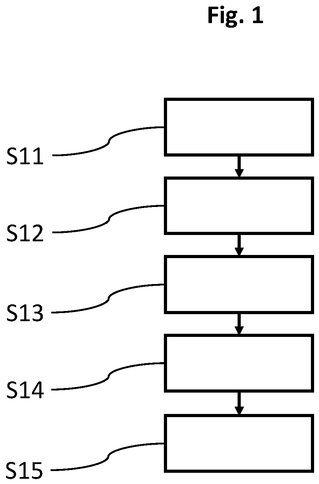

Figur 1 zeigt ein Flussdiagramm des erfindungsgemäßen Verfahrens zur Plausibilisierung einer Strommessung zwischen einem elektrischen Energiespeichersystem und einem elektrischen Verbraucher, wobei zwischen beiden ein Kondensator und ein Schaltelement angeordnet ist, gemäß einer ersten Ausführungsform.

Dabei wird in einem ersten Schritt S11 ein elektrischer Strom zwischen dem elektrischen Energiespeichersystem und dem elektrischen Verbraucher gemessen und somit ein erster Stromwert ermittelt. Somit kann beispielsweise festgestellt werden, ob das Energiespeichersystem in einem Zustand mit niedrigem Energieverbrauch ist.

In einem zweiten Schritt S12 wird das Schaltelement zum Trennen des elektrischen Energiespeichersystems von dem elektrischen Verbraucher angesteuert. Sobald das Schaltelement die beiden Komponenten getrennt hat, wird der elektrische Verbraucher von dem Kondensator mit elektrischer Energie versorgt.

In einem dritten Schritt S13 wird eine erste elektrische Spannung an dem Kondensator ermittelt. Dies kann insbesondere nach einer vordefinierten Zeitspanne nach dem Trennen des elektrischen Energiespeichersystems von dem elektrischen Verbraucher erfolgen.

In einem vierten Schritt S14 wird ein zweiter Stromwert in Abhängigkeit der ermittelten Spannung ermittelt. Mittels der ermittelten Spannung und gegebenenfalls der vordefinierten Zeitspanne kann auf den fließenden Strom rückgeschlossen werden.

In einem fünften Schritt S15 wird die Strommessung nun durch einen Vergleich des ersten Stromwertes mit dem zweiten Stromwert plausibilisiert. Je nach ermitteltem zweitem Stromwert können entsprechende Sicherheitsreserven beziehungsweise vorgesehene Messunsicherheiten der Strommessung beziehungsweise bei der Stromwertermittlung reduziert werden, da beispielsweise ein Störungseinfluss durch elektrische oder elektromagnetische Störungen beziehungsweise durch einen Wandler-Offset bei der zweiten Spannungsmessung als unwesentlich eingeschätzt werden kann, da vorzugsweise eine Spannungsänderung im Voltbereich stattfindet.

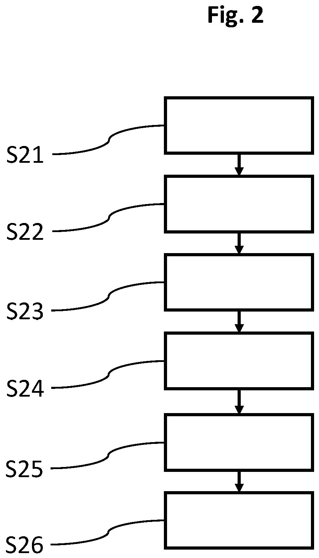

Figur 2 zeigt ein Flussdiagramm des erfindungsgemäßen Verfahrens gemäß einer zweiten Ausführungsform. Dabei entsprechen die Schritte S21 bis S25 den oben beschriebenen Schritten S11 bis S15. Zusätzlich wird ein sechster Schritt S26 ausgeführt.

In dem sechsten Schritt S26 wird die Funktionsfähigkeit des Schaltelementes in Abhängigkeit der ermittelten ersten elektrischen Spannung an dem Kondensator überprüft. Dabei wird ausgenutzt, dass die erste elektrische Spannung je nach den konkret ausgeführten Messpunkten bei korrekter Funktionsfähigkeit beispielsweise beim Trennen sinkt und beim einem gegebenenfalls nachfolgenden Verbinden des elektrischen Energiespeichersystems mit dem Verbraucher wieder steigt. Sollte dies nicht der Fall sein, liegt keine korrekte Funktionsfähigkeit vor. Dazu kann beispielsweise die erste elektrische Spannung mit einer vordefinierten Spannungsgrenze verglichen werden, die zur Unterscheidung der Funktionsfähigkeit herangezogen werden kann. Der sechste Schritte S26 kann dabei auch an anderer Stelle ausgeführt werden, solange zuvor der Schritt der Ermittlung der ersten elektrischen Spannung an dem Kondensator durchgeführt wurde, beispielsweise direkt nach diesem Schritt.

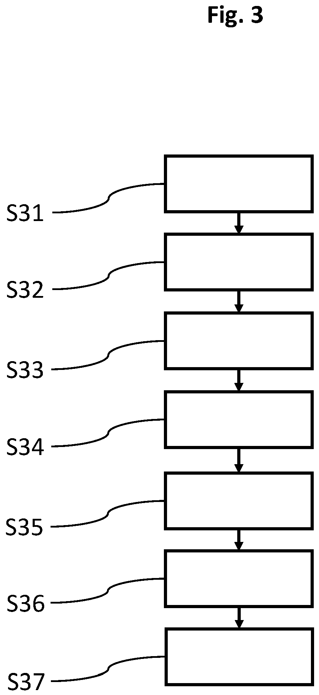

Figur 3 zeigt ein Flussdiagramm des erfindungsgemäßen Verfahrens gemäß einer zweiten Ausführungsform. Dabei entspricht der erste Schritt S31 dem oben beschriebenen ersten Schritt S11.

In einem zweiten Schritt S32 wird der so ermittelte erste Stromwert mit einem vordefinierten ersten Stromgrenzwert verglichen. Liegt der erste Stromwert beispielsweise betragsmäßig unter dem vordefinierten ersten Stromgrenzwert, wird mit dem nächsten dritten Schritt S33 fortgefahren. Ansonsten wird mit dem ersten Schritt S31 fortgefahren.

Der dritte Schritt S33 entspricht dem oben beschrieben zweiten Schritt S12. Anschließend folgen ein vierter Schritt S34, ein fünfter Schritt S35 und ein sechster Schritt S36, welche den oben beschrieben Schritten S13, S14 und S15 entsprechen.

In einem anschließenden Schritt S37 wird wieder das Schaltelement angesteuert, dieses Mal zum Verbinden des elektrischen Energiespeichersystems mit dem Verbraucher, sodass dieser wieder von dem elektrischen Energiespeichersystem mit Energie versorgt wird.

Alternativ und/oder zusätzlich kann bei allen Ausführungsbeispielen vorgesehen sein, dass bei Unterschreiten oder Überschreiten eines vordefinierten Spannungsgrenzwertes durch die die ermittelte erste Spannung an dem Kondensator unmittelbar ein Ansteuern des Schaltelementes zum Verbinden des elektrischen Energiespeichersystems erfolgt, um eine Unterbrechung der Stromversorgung zu verhindern. Dies könnte beispielsweise aus einer zu starken Entladung des Kondensators durch erhöhten Energieverbrauch des Verbrauchers resultieren.

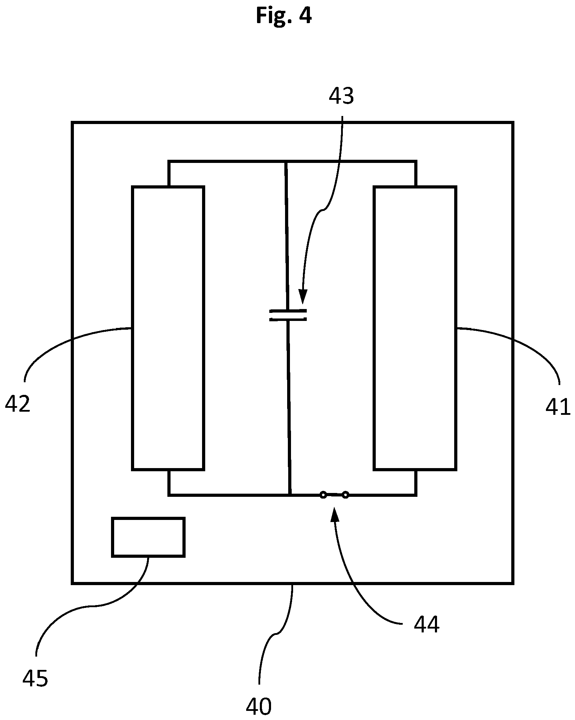

Figur 4 zeigt eine schematische Darstellung einer erfindungsgemäßen Vorrichtung 40 gemäß einer Ausführungsform. Dabei umfasst die Vorrichtung 40 ein elektrisches Energiespeichersystem 41 und einen elektrischen Verbraucher 42. Zwischen beiden Komponenten ist ein Kondensator 43 und ein Schaltelement 44 zum Trennen des elektrischen Energiespeichersystems 41 von dem elektrischen Verbraucher 42 angeordnet, sodass der elektrische Verbraucher 42 bei Trennung von dem Kondensator 43 mit elektrischer Energie versorgt wird. In Figur 4 ist das Schaltelement 44 in verbundenem Zustand dargestellt. Weiterhin umfasst die Vorrichtung 40 eine elektronische Steuereinheit 45, die eingerichtet ist, alle Schritte eines erfindungsgemäßen Verfahrens auszuführen.

## Patentansprüche

1. Verfahren zur Plausibilisierung einer Strommessung zwischen einem elektrischen Energiespeichersystem (41) und einem elektrischen Verbraucher (42), wobei zwischen beiden ein Kondensator (43) und ein Schaltelement (44) angeordnet ist, umfassend die Schritte:
a) Ermitteln eines ersten Stromwertes durch Messen eines elektrischen Stromes zwischen dem elektrischen Energiespeichersystem (41) und dem elektrischen Verbraucher (42);
b) Ansteuern des Schaltelementes (44) zum Trennen des elektrischen Energiespeichersystems (41) von dem elektrischen Verbraucher (42), sodass der elektrische Verbraucher (42) von dem Kondensator (43) mit elektrischer Energie versorgt wird;
c) Ermitteln einer ersten elektrischen Spannung an dem Kondensator (43);
d) Ermitteln eines zweiten Stromwertes in Abhängigkeit der ermittelten Spannung;
e) Plausibilisieren der Strommessung durch Vergleich des ersten Stromwertes mit dem zweiten Stromwert.

2. Verfahren gemäß dem vorhergehenden Anspruch, weiterhin umfassend:
f) Anpassen von bei der Strommessung zu berücksichtigenden Messunsicherheiten in Abhängigkeit des zweiten Stromwertes.

3. Verfahren gemäß einem der vorhergehenden Ansprüche, weiterhin umfassend:
g) Überprüfen der Funktionsfähigkeit des Schaltelementes (44) in Abhängigkeit der ermittelten ersten elektrischen Spannung an dem Kondensator (43).

4. Verfahren gemäß einem der vorhergehenden Ansprüche, weiterhin umfassend:
h) Vergleichen des ersten Stromwertes mit einem vordefinierten ersten Stromgrenzwert, wobei das Ansteuern des Schaltelementes (44) zum Trennen in Abhängigkeit des Vergleichs erfolgt;

5. Verfahren gemäß einem der vorhergehenden Ansprüche, weiterhin umfassend:
i) Ansteuern des Schaltelementes (44) zum Verbinden des elektrischen Energiespeichersystems (41) mit dem Verbraucher, sodass der elektrische Verbraucher (42) von dem elektrischen Energiespeichersystem (41) mit elektrischer Energie versorgt wird.

6. Verfahren gemäß dem vorhergehenden Anspruch, wobei das Ansteuern in Abhängigkeit einer zweiten elektrischen Spannung an dem Kondensator (43) erfolgt.

7. Computerprogramm, welches eingerichtet ist, alle Schritte des Verfahrens nach einem der vorhergehenden Ansprüche auszuführen.

8. Maschinenlesbares Speichermedium, auf dem das Computerprogramm nach dem vorhergehenden Anspruch gespeichert ist.

9. Elektronische Steuereinheit (45), die eingerichtet ist, alle Schritte des Verfahrens nach einem der Ansprüche 1 bis 5 auszuführen.

10. Vorrichtung (40), umfassend ein elektrisches Energiespeichersystem (41) und einen elektrischen Verbraucher (42), wobei zwischen beiden ein Kondensator (43) und ein Schaltelement (44) angeordnet ist, sowie eine elektronische Steuereinheit (45) gemäß dem vorhergehenden Anspruch.

## Claims

1. Method for checking the plausibility of a current measurement between an electrical energy storage system (41) and an electrical consumer (42), wherein a capacitor (43) and a switching element (44) are arranged between the two, comprising the steps of:
a) ascertaining a first current value by measuring an electrical current between the electrical energy storage system (41) and the electrical consumer (42);
b) actuating the switching element (44) to disconnect the electrical energy storage system (41) from the electrical consumer (42) so that the electrical consumer (42) is supplied with electrical energy by the capacitor (43);
c) ascertaining a first electrical voltage across the capacitor (43);
d) ascertaining a second current value on the basis of the ascertained voltage;
e) checking the plausibility of the current measurement by comparing the first current value with the second current value.

2. Method according to the preceding claim, furthermore comprising:
f) adapting measurement uncertainties to be taken into account in the current measurement, on the basis of the second current value.

3. Method according to either of the preceding claims, furthermore comprising:
g) checking the operability of the switching element (44) on the basis of the ascertained first electrical voltage across the capacitor (43).

4. Method according to one of the preceding claims, furthermore comprising:
h) comparing the first current value with a predefined first current limit value, wherein the switching element (44) is actuated to disconnect on the basis of the comparison.

5. Method according to one of the preceding claims, furthermore comprising:
i) actuating the switching element (44) to connect the electrical energy storage system (41) to the consumer so that the electrical consumer (42) is supplied with electrical energy by the electrical energy storage system (41).

6. Method according to the preceding claim, wherein the actuation is performed on the basis of a second electrical voltage across the capacitor (43).

7. Computer program which is configured to carry out all the steps of the method according to one of the preceding claims.

8. Machine-readable storage medium on which the computer program according to the preceding claim is stored.

9. Electronic control unit (45) which is configured to carry out all the steps of the method according to one of Claims 1 to 5.

10. Apparatus (40) comprising an electrical energy storage system (41) and an electrical consumer (42), wherein a capacitor (43) and a switching element (44) are arranged between the two, and an electronic control unit (45) according to the preceding claim.

## Revendications

1. Procédé de contrôle de la plausibilité d'une mesure de courant entre un système de stockage d'énergie électrique (41) et un consommateur électrique (42), un condensateur (43) et un élément de commutation (44) étant disposés entre les deux, comprenant les étapes :
a) détermination d'une première valeur de courant par mesure d'un courant électrique entre le système de stockage d'énergie électrique (41) et le consommateur électrique (42) ;
b) commande de l'élément de commutation (44) pour séparer le système de stockage d'énergie électrique (41) du consommateur électrique (42), de sorte que le consommateur électrique (42) est alimenté en énergie électrique par le condensateur (43) ;
c) détermination d'une première tension électrique aux bornes du condensateur (43) ;
d) détermination d'une deuxième valeur de courant en fonction de la tension déterminée ;
e) contrôle de la plausibilité de la mesure du courant par comparaison de la première valeur de courant avec la deuxième valeur de courant.

2. Procédé selon la revendication précédente, comprenant en outre :
f) adaptation des incertitudes de mesure à prendre en compte lors de la mesure du courant en fonction de la deuxième valeur de courant.

3. Procédé selon l'une des revendications précédentes, comprenant en outre :
g) vérification de l'aptitude fonctionnelle de l'élément de commutation (44) en fonction de la première tension électrique déterminée aux bornes du condensateur (43).

4. Procédé selon l'une des revendications précédentes, comprenant en outre :
h) comparaison de la première valeur de courant avec une première valeur limite de courant prédéfinie, la commande de l'élément de commutation (44) pour la séparation s'effectuant en fonction de la comparaison.

5. Procédé selon l'une des revendications précédentes, comprenant en outre :
i) commande de l'élément de commutation (44) pour relier le système de stockage d'énergie électrique (41) au consommateur électrique, de sorte que le consommateur électrique (42) est alimenté en énergie électrique par le système de stockage d'énergie électrique (41).

6. Procédé selon la revendication précédente, la commande étant effectuée en fonction d'une deuxième tension électrique aux bornes du condensateur (43).

7. Programme informatique, lequel est conçu pour exécuter toutes les étapes du procédé selon l'une des revendications précédentes.

8. Moyen de stockage lisible par machine, sur lequel est enregistré un programme informatique selon la revendication précédente.

9. Unité de commande électronique (45), qui est conçue pour exécuter toutes les étapes du procédé selon l'une des revendications 1 à 5.

10. Dispositif (40) comprenant un système de stockage d'énergie électrique (41) et un consommateur électrique (42), un condensateur (43) et un élément de commutation (44) étant disposés entre les deux, ainsi qu'une unité de commande électronique (45) selon la revendication précédente.
